# EUROPÄISCHE PATENTANMELDUNG

(11) **EP 0 576 708 A1**
(43) Veröffentlichungstag der Anmeldung: **05.01.1994**
(21) Anmeldenummer: 92111167.0
(22) Anmeldetag: 01.07.1992
(51) Int. Cl.: H01L 23/495, H01L 21/60

(54) **Integrierter Schaltkreis mit Leiterrahmen**

(71) Anmelder: SIEMENS AKTIENGESELLSCHAFT, D-80333 München (DE)
(72) Erfinder: Savignac, Dominique, Dr. rer.nat., W-8045 Ismaning (DE); Alpern, Peter, Dr.rer.nat., W-8000 München 45 (DE); Tilgner, Rainer, Dr.rer.nat., W-8000 München 81 (DE); Müller, Klaus, Dr.rer.nat., W-8400 Regensburg (DE)

(57) **Zusammenfassung**

Ein Halbleiterchip CH ist mit auf ihm angeordneten Anschlußflächen Pd in eine Plastikmasse M hermetisch eingeschlossen. Zur Kontaktierung des Halbleiterchips CH sind erste Abschnitte 1 von Leads L mechanisch stabil mit den Anschlußflächen Pd verbunden. Die Leads L sind in zweiten Abschnitten 2 durch die Plastikmasse M hindurch nach außen geführt, wo sie Pins P als Anschlüsse des Schaltkreises bilden. In dritten Abschnitten 3 der Leads L sind die Leads L mit dem Halbleiterchip CH verklebt. Erfindungsgemäß ist vorgesehen, daß zur Klebung der Leads L zwischen dem jeweiligen Lead L und dem Halbleiterchip CH Klebstoff Adh angebracht ist. Der Klebstoff Adh befindet sich im wesentlichen ausschließlich zwischen dem jeweiligem Lead L und dem Halbleiterchip CH, so daß solche Oberflächenbereiche des Halbleiterchips CH, die sich zwischen benachbarten Leads L befinden, frei von Klebstoff Adh sind.

## Beschreibung

Die Erfindung betrifft einen integrierten Schaltkreis nach dem Oberbegriff des Patentanspruches 1.

Ein gattungsgemäßer Schaltkreis ist bekannt aus "IEEE Proceedings of the 38th ECC, Los Angeles 1988", Seiten 552 bis 557: "Volume Production of Unique Plastic Surface-Mount Modules for the IBM 80-ns 1-Mbit DRAM Chip by Area Wire Bond Techniques". Bei diesem Schaltkreis sind die zur Kontaktierung des Schaltkreises verwendeten Leads oberhalb des im Schaltkreis enthaltenen Halbleiterchips angeordnet. Eine solche Anordnung ist der Fachwelt bekannt unter dem Begriff "LOC-Technik" (= Lead on Chip). Um die Oberfläche des Halbleiterchips vor Verletzungen durch die Leads zu schützen (Verletzungen könnten z.B. bei der Montage von Halbleiterchip und Leads in einem Gehäuse auftreten) und um gleichzeitig die Leads bzgl. des Halbleiterchips zu fixieren, sind auf der Chipoberfläche Selbstklebefolien großflächig angeordnet.

Erprobungen solcher Schaltkreise haben gezeigt, daß insbesondere bei ständig wechselnden Temperaturverhältnissen Schäden auftreten wie z.B. Risse im Schaltkreisgehäuse und Brüche des Halbleiterchips. Als Ursache für diese Schäden konnte ermittelt werden, daß aufgrund der Temperaturänderungen zwischen der Plastikmasse des Gehäuses eines solchen Schaltkreises und den Selbstklebefolien Delamination auftritt. In geringerem Umfang tritt diese Delamination auch zwischen den Selbstklebefolien und dem Halbleiterchip auf. Während der Halbleiterchip an seiner Oberfläche bzw. die darauf befindlichen Selbstklebefolien aufgrund dieser Delamination lose sind gegenüber dem Schaltkreisgehäuse, ist der Halbleiterchip an seiner Unterseite fest mit dem Schaltkreisgehäuse verbunden. Aufgrund unterschiedlicher Wärmeausdehnungskoeffizienten von Gehäuse und Halbleiterchip bilden sich bei Temperaturänderungen an der Chipoberseite Scherkräfte aus, die letztendlich zu den beschriebenen Schäden führen.

Aufgabe der vorliegenden Erfindung ist es, einen integrierten Schaltkreis zu schaffen, bei dem solche Schäden nicht auftreten können.

Diese Aufgabe wird bei einem gattungsgemäßen Schaltkreis gelöst mittels der kennzeichnenden Merkmale des Patentanspruches 1. Vorteilhafte Aus- und Weiterbildungen sind in Unteransprüchen gekennzeichnet.

Die Erfindung wird nachstehend anhand der Zeichnung erläutert. Es zeigen:
- Die Figuren 1 und 2: den bekannten Schaltkreis in Draufsicht und im Querschnitt,
- die Figuren 3 bis 8 und 10: verschiedene Ausführungsformen des erfindungsgemäßen Schaltkreises, jeweils in Draufsicht und Querschnitt,
- die Figur 9: eine vorteilhafte Einzelheit.

Aus Gründen der Übersichtlichkeit sind die Darstellungen auf das Wesentliche beschränkt. Insbesondere sind lediglich zwei Anschlußpins dargestellt, obwohl ein integrierter Schaltkreis üblicherweise wesentlich mehr Anschlußpins aufweist, wie dem Fachmann bekannt ist.

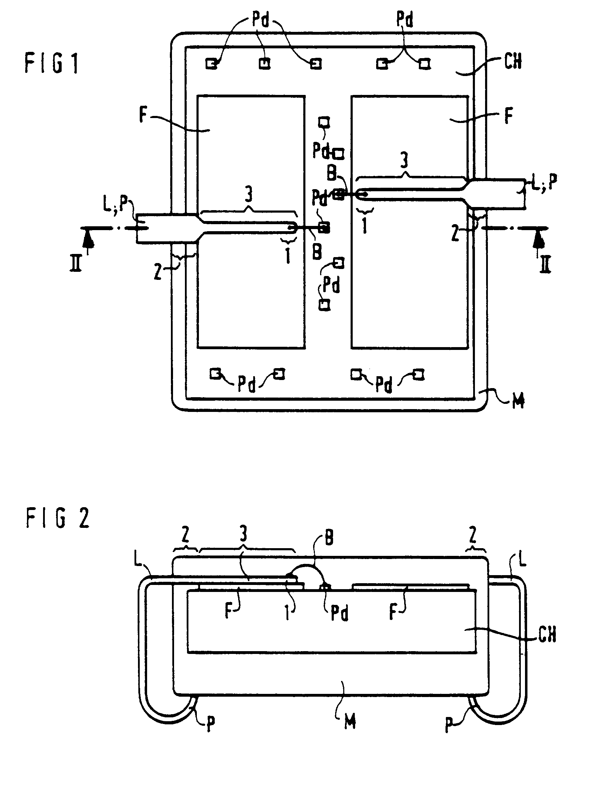

Figur 1 zeigt den bekannten Schaltkreis in geöffnetem Zustand in Draufsicht. Figur 2 zeigt den Schaltkreis nach Figur 1 im Querschnitt entlang einer Schnittlinie II (siehe Figur 1), allerdings im nicht-geöffneten Zustand. Als Gehäuse dient eine Plastikmasse M, welches üblicherweise mittels Spritzens der Plastikmasse M herstellbar ist. Innerhalb des Gehäuses, d.h. innerhalb der Plastikmasse M, ist ein Halbleiterchip CH hermetisch eingeschlossen. Der Halbleiterchip CH weist Anschlußflächen Pd auf (allgemein als "pads" bekannt) zur Kontaktierung des Halbleiterchips CH.

Weiterhin enthält der Schaltkreis sogenannte Leads L, die ebenfalls der Kontaktierung des Halbleiterchips CH dienen. Sie sind entsprechend der sogenannten LOC-Technik angeordnet, d.h. oberhalb des Halbleiterchips CH. Die Leads L weisen, entsprechend ihrer Funktion, mehrere Abschnitte (1, 2, 3, P) auf: In einem ersten Abschnitt 1 ist ein jeweiliges Lead L mit einer jeweiligen Anschlußfläche Pd mechanisch stabil verbunden (B), beispielsweise mittels eines Drahtes. Eine solche Verbindung B wird im allgemeinen als Bond-Verbindung bezeichnet. Die Leads L sind im zweiten Abschnitt 2 durch die Plastikmasse M des integrierten Schaltkreises hindurch nach außen geführt. Außerhalb des integrierten Schaltkreises bilden sie allgemein als Pins P bezeichnete Anschlüsse des Schaltkreises. Der dritte Abschnitt 3 eines jeweiligen Leads L befindet sich innerhalb des Gehäuses des integrierten Schaltkreises. Er umfaßt auch den ersten Abschnitt 1 des jeweiligen Leads L. Er schließt sich an den zweiten Abschnitt 2 an.

Bei diesem integrierten Schaltkreis nach dem Stande der Technik ist auf derjenigen Oberfläche des Halbleiterchips CH, welche die Anschlußflächen Pd aufweist, eine doppelseitige Klebefolie F vorgesehen, die zwischen der Oberfläche des Halbleiterchips CH und den Leads L angeordnet ist. Sie umfaßt praktisch die gesamte Oberfläche mit Ausnahme derjenigen Bereiche, in denen die Anschlußflächen Pd angeordnet sind. Falls, wie beim integrierten Schaltkreis nach den Figuren 1, 2 angenommen, der Halbleiterchip CH Anschlußflächen Pd aufweist, die entlang einer angenommenen Mittelachse des Halbleiterchips CH angeordnet sind, so sind anstelle einer einzigen Klebefolie F zwei Klebefolien F nebeneinander so angeordnet, daß die Anschlußflächen Pd frei bleiben. Die Klebefolie F dient im wesentlichen zwei Zwecken: Zum einen dient sie vor und während des Spritzvorganges, d.h. vor und während des Aufbringens des Gehäuses, einem sicheren Fixieren der Leads L bezüglich des Halbleiterchips CH, so daß insbesondere keine Beschädigung der Verbindungen B auftreten können (beispielsweise durch unbeabsichtigtes Verschieben der Leads L). Zum anderen schützt sie die Oberfläche des Halbleiterchips CH vor Beschädigungen durch die Leads L, insbesondere vor Beschädigungen durch Kratzer. Bei diesem Schaltkreis (Figuren 1, 2) nach dem Stande der Technik treten die eingangs beschriebenen Nachteile und Schäden auf.

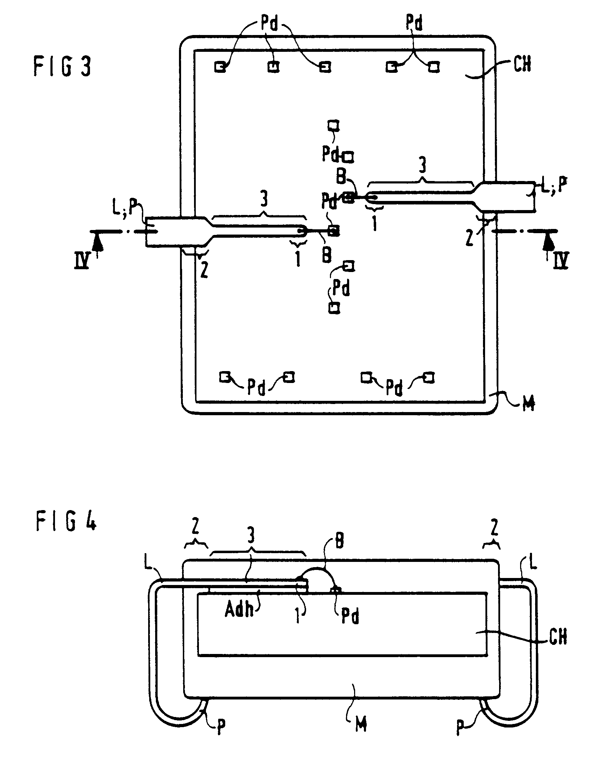

Die Figuren 3 und 4 zeigen eine erste Ausführungsform des erfindungsgemäßen integrierten Schaltkreises in Draufsicht (Figur 3) und im Querschnitt (Figur 4). Die Ausführungsform nach den Figuren 3, 4 weist dieselben Merkmale auf wie der Schaltkreis nach den Figuren 1, 2 mit Ausnahme der Klebefolie F. Eine Klebefolie F entsprechend den Figuren 1, 2, die im wesentlichen den gesamten Halbleiterchip CH bedeckt, ist beim erfindungsgemäßen Schaltkreis nicht vorgesehen. Stattdessen ist bei jedem einzelnen Lead L zwischen dem Lead L und dem Halbleiterchip CH ein Klebstoff Adh aufgebracht. Er befindet sich im wesentlichen ausschließlich zwischen dem jeweiligen Lead L und dem Halbleiterchip CH, abgesehen von einer beim Aufbringen der Leads L ggf. seitlich hervorquellenden geringen Menge von Überschuß des Klebstoffes Adh. Sinn und Zweck des so aufgebrachten Kelbstoffes Adh ist derselbe wie der bezüglich des Schaltkreises nach den Figuren 1, 2 bereits beschriebene Sinn und Zweck der Klebefolie F, nämlich Fixieren der Leads L vor und während des Spritzvorganges sowie Schutz vor Beschädigung des Halbleiterchips CH durch die Leads L. Bei dem erfindungsgemäßen Schaltkreis sind demzufolge diejenigen Oberflächenbereiche des Halbleiterchips CH, die sich zwischen den Leads L befinden, frei von Klebefolie F bzw. Klebstoff Adh. Somit herrschen in diesen Oberflächenbereichen dieselben Adhäsionsverhältnisse bezüglich der diese Bereiche bedeckenden Teile der Plastikmasse M wie an der den Anschlußflächen Pd abgewandten Chipunterseite mit ihrer Oberfläche. Demzufolge können sich die bezüglich des Standes der Technik beschriebenen zerstörerischen Vorgänge und Kräfte nicht mehr aufbauen.

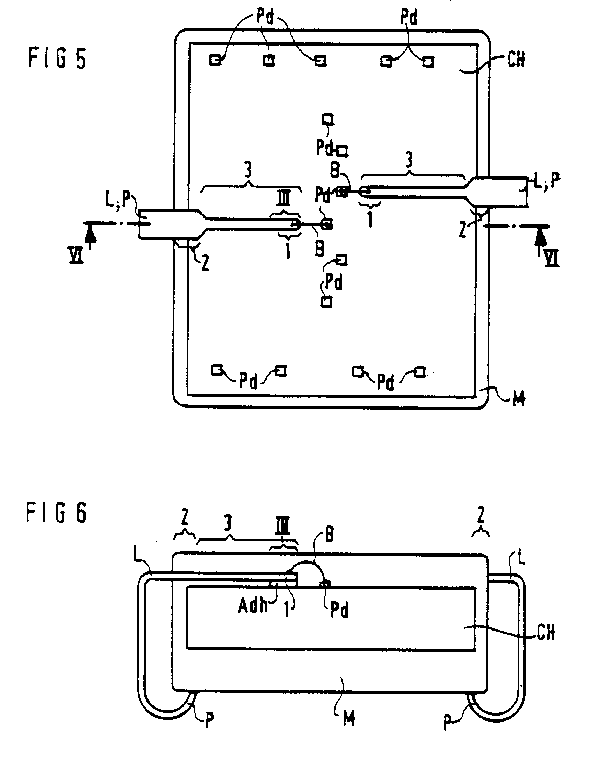

Die Figuren 5 und 6 zeigen eine zweite Ausführungsform des erfindungsgemäßen Schaltkreises. Sie entspricht großen Teils der beschriebenen ersten Ausführungsform. Allerdings ist der Klebstoff Adh nicht, wie der ersten Ausführungsform, im gesamten Bereich des dritten Abschnittes 3 eines jeweiligen Leads L angeordnet, sondern lediglich in einem Teilbereich III des dritten Abschnittes 3. Der Teilbereich III umfaßt insbesondere den ersten Abschnitt 1, wie aus Figur 6 ersichtlich.

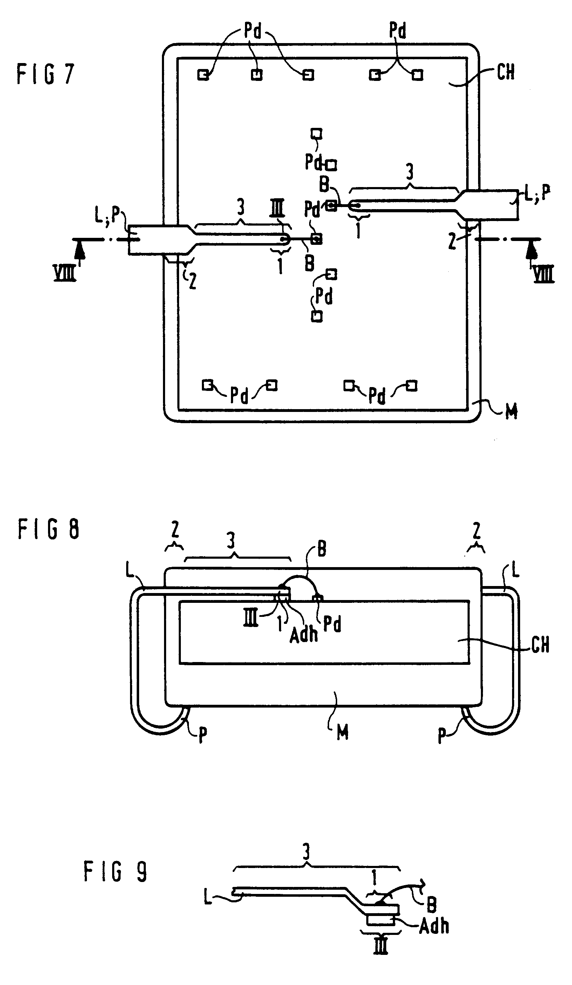

Die Figuren 7 und 8 zeigen eine dritte Ausführungsform der Erfindung. Sie ist eine Weiterbildung der zweiten Ausführungsform und unterscheidet sich von dieser dadurch, daß der Teilbereich III im wesentlichen punktförmig ausgestaltet ist. Vorteilhafterweise befindet sich der so ausgestaltete Teilbereich III unterhalb der Stelle des ersten Abschnittes 1, an der die Verbindung B auf dem betreffenden Lead L befestigt ist.

Figur 9 zeigt ausschnittsweise eine von der dritten Ausführungsform abgeleitete vierte Ausführungsform des erfindungsgemäßen Schaltkreises. Sie unterscheidet sich von der dritten Ausführungsform dadurch, daß die Leads L an derjenigen Stelle des dritten Abschnittes 3, an der der jeweilige Teilbereich III beginnt, gekröpft sind. Dies hat den Vorteil, daß sich beim Spritzvorgang zwischen den Leads L und der Oberfläche des Halbleiterchips CH in den außerhalb der Teilbereiche III verbleibenden Teilbereichen der dritten Abschnitte 3 mehr Plastikmasse M anlagern kann als bei den bisher beschriebenen Ausführungsformen, weil die Abstände zwischen den Leads L und dem Halbleiterchip CH an den betreffenden Stellen entsprechend größer sind. Dies hat eine größere mechanische Stabilisierung der Leads durch den Spritzvorgang zur Folge.

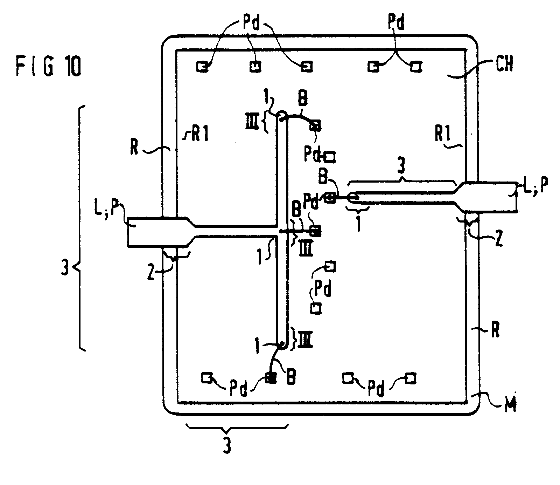

Bei den Ausführungsformen nach den Figuren 5 bis 9 liegen, ebenso wie bei der noch zu beschreibenden Ausführungsform nach Figur 10, die ersten Abschnitte 1 jeweils in den Teilbereichen III der dritten Abschnitte 3.

Figur 10 zeigt eine weitere vorteilhafte Ausführungsform der Erfindung. Dabei weist wenigstens eines der Leads L des Schaltkreises im dritten Abschnitt 3 mehrere erste Abschnitte 1 und mehrere Teilbereiche III auf. Dabei befindet sich ein jeweiliger erster Abschnitt 1 in einem jeweiligen Teilbereich III. Bei einer solchen Ausgestaltung läßt sich dem Schaltkreis im Betrieb dann beispielsweise ein Versorgungspotential (VDD oder VSS) an mehreren Stellen des Halbleiterchips CH gleichzeitig zuführen mit einem geringeren Spannungsabfall aufgrund eines ohm'schen Widerstandes entlang der betreffenden Leads L als bei einer Zuführung mittels Verbindungsleitung innerhalb des Halbleiterchips von einem einzigen ersten Abschnitt 1 aus, da eine solche Verbindungsleitung einen höheren ohm'schen Widerstand aufwiese als die Zuführung mittels mehrerer erster Abschnitte 1 (ein Lead L hat einen wesentlich größeren Querschnitt als eine Verbindungsleitung im Halbleiterchip CH).

Die Ausführungsformen nach den Figuren 3 bis 8 und 10 zeigen über die bislang beschriebenen Merkmale hinaus noch ein weiteres, vorteilhaftes Merkmal: Dabei sind auf der die Anschlußflächen Pd aufweisenden Oberfläche des Halbleiterchips CH Randbereiche R, die entlang von Längsseiten R1 des Halbleiterchips CH verlaufen, frei von Anschlußflächen Pd. Mit dieser Anordnung ist es möglich, elektrische Schaltungen, die im Halbleiterchip CH enthalten sind, bezüglich ihres Layouts so zu gestalten, daß sie bis in diese Randbereiche R reichen. Dies führt zu einem besseren Ausnützen der Chipfläche des Halbleiterchips CH durch die im Halbleiterchip CH enthaltenen elektrischen Schaltungen.

## Patentansprüche

1. Integrierter Schaltkreis mit folgenden Merkmalen:
- In eine Plastikmasse (M) ist ein Halbleiterchip (CH) mit auf ihm angeordneten Anschlußflächen (Pd) hermetisch eingeschlossen,
- zur Kontaktierung des Halbleiterchips (CH) sind erste Abschnitte (1) von Leads (L) mechanisch stabil mit den Anschlußflächen (Pd) verbunden,
- die Leads (L) sind in zweiten Abschnitten (2) durch die Plastikmasse (M) hindurch nach außen geführt, wo die Leads (L) Pins (P) als Anschlüsse des Schaltkreises bilden,
- in dritten Abschnitten (3) der Leads (L), die sich oberhalb des Halbleiterchips (CH) befinden, sind die Leads (L) mit dem Halbleiterchip (CH) verklebt,
**gekennzeichnet durch**
folgende Merkmale:
Zur Klebung ist je einzelnem Lead (L) zwischen dem Lead (L) und dem Halbleiterchip (CH) Klebstoff (Adh) angebracht, der sich im wesentlichen ausschließlich zwischen dem jeweiligen Lead (L) und dem Halbleiterchip (CH) befindet, so daß Oberflächenbereiche des Halbleiterchips (CH), die sich zwischen benachbarten Leads (L) befinden, frei vom Klebstoff (Adh) sind.

2. Integrierter Schaltkreis nach Anspruch 1,
**dadurch gekennzeichnet,**
daß der Klebstoff (Adh) bei einem jeweiligen Lead (L) im Bereich des gesamten dritten Abschnitts (3) zwischen dem Lead (L) und dem Halbleiterchip (CH) angeordnet ist.

3. Integrierter Schaltkreis nach Anspruch 1,
**dadurch gekennzeichnet,**
daß der Klebstoff (Adh) bei einem jeweiligen Lead (L) nur in einem Teilbereich (III) des dritten Abschnittes (3) zwischen dem Lead (L) und dem Halbleiterchip (CH) angeordnet ist.

4. Integrierter Schaltkreis nach Anspruch 3,
**dadurch gekennzeichnet,**
daß der Teilbereich (III) punktförmig ist.

5. Integrierter Schaltkreis nach Anspruch 3 oder 4,
**dadurch gekennzeichnet,**
daß das jeweilige Lead (L) im dritten Abschnitt (3) an derjenigen Stelle, wo der Teilbereich (III) beginnt, gekröpft ist.

6. Integrierter Schaltkreis nach einem der Ansprüche 3 bis 5, **dadurch gekennzeichnet,**
daß sich die ersten Abschnitte (1) in den Teilbereichen (III) der dritten Abschnitte (3) befinden.

7. Integrierter Schaltkreis nach einem der Ansprüche 3 bis 6, **dadurch gekennzeichnet,**
daß wenigstens eines der Leads (L) des Schaltkreises mehr als einen ersten Abschnitt (1) und mehr als einen Teilbereich (III) aufweist.

8. Integrierter Schaltkreis nach Anspruch 7,
**dadurch gekennzeichnet,**
daß sich ein jeweiliger erster Abschnitt (1) in einem jeweiligen Teilbereich (III) des dritten Abschnitts (3) befindet.

9. Integrierter Schaltkreis nach einem der vorhergehenden Ansprüche, **dadurch gekennzeichnet,**
daß Randbereiche (R) des Halbleiterchips (CH), die entlang von Längsseiten (R1) des Halbleiterchips (CH) verlaufen, frei von Kontaktflächen (Pd) sind.
